(19) Europäisches Patentamt
European Patent Office
Office européen des brevets

(11) EP 1 593 751 A1

(12) **EUROPEAN PATENT APPLICATION**
published in accordance with Art. 158(3) EPC

(43) Date of publication:
**09.11.2005 Bulletin 2005/45**

(21) Application number: **04702064.9**

(22) Date of filing: **14.01.2004**

(51) Int Cl.[7]: **C23C 8/36**, H05H 1/46, H01J 37/32, C22C 21/06

(86) International application number:
**PCT/JP2004/000179**

(87) International publication number:
**WO 2004/063418 (29.07.2004 Gazette 2004/31)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **14.01.2003 JP 2003006213**
**05.02.2003 JP 2003028476**

(71) Applicants:
- **TOKYO ELECTRON LIMITED**
  **Minato-ku, Tokyo 107-8481 (JP)**
- **OHMI, Tadahiro**
  **Sendai-shi, Miyagi 980-0813 (JP)**

(72) Inventors:
- **OHMI, Tadahiro**
  **Sendai-shi, Miyagi 980-0813 (JP)**
- **SHIRAI, Yasuyuki**
  **Sendai-shi, Miyagi 980-0866 (JP)**
- **KITANO, Masafumi, c/o Dept of Electronic Eng.**
  **Aramaki (JP)**

(74) Representative: **Goddar, Heinz J.**
**Forrester & Boehmert**
**Pettenkoferstrasse 20-22**
**80336 München (DE)**

(54) **MEMBER OF APPARATUS FOR PLASMA TREATMENT, MEMBER OF TREATING APPARATUS, APPARATUS FOR PLASMA TREATMENT, TREATING APPARATUS AND METHOD OF PLASMA TREATMENT**

(57) According to the present invention, gas in which oxygen gas and krypton are mixed is introduced into a process vessel from a process gas supply source while a processing target made of an aluminum alloy in the process chamber is kept at a predetermined temperature, and plasma is generated in the process vessel by a microwave. Radical oxidation processing by an oxygen radical generated thereby is applied to a surface of the processing target, so that a dense oxide coating film with improved corrosion resistance is formed on the surface of the processing target.

FIG.1

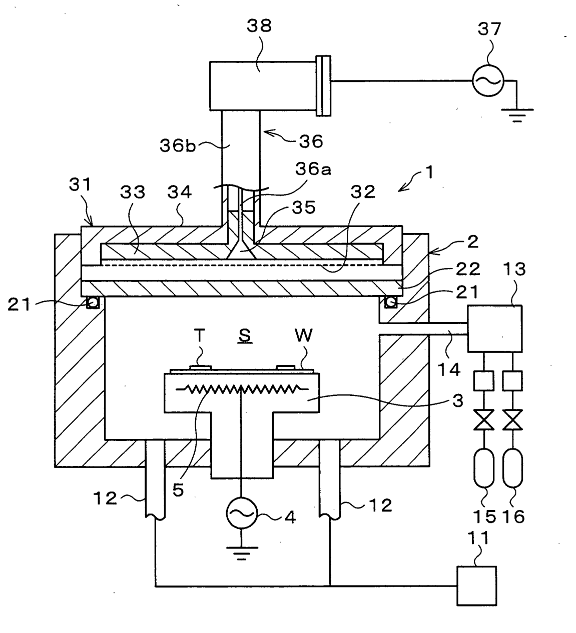


EP 1 593 751 A1

## Description

### Technical Field

The present invention relates to a member of a plasma processing apparatus, a member of a processing apparatus, a plasma processing apparatus, a processing apparatus and a method of plasma processing.

### Background Art

For a member, for example, a chamber, used in an apparatus performing plasma processing, an aluminum alloy is used in consideration of its weight reduction, and in order to prevent an inner wall of the chamber from being corroded by active species such as ions and by corrosive gas when various kinds of gases are dissociated by plasma, the inner wall of the chamber is subjected to oxidation processing in advance so that a corrosion-resistant coating film of $Al_2O_3$ is formed on its surface.

The aforesaid oxidation processing has been conventionally applied by a method called anodic oxidation processing (for example, Japanese Patent Application Laid-open No. Hei 7-216589).

The coating film of $Al_2O_3$ formed by the anodic oxidation processing is basically a porous film and its surface has irregularities. Therefore, post processing such as the filling of pores is applied to the coating film in a manner such that, for example, the coating film is exposed to high-temperature vapor so that molecules of the film absorb moisture to expand.

However, even with such post processing, if the anodically oxidized aluminum alloy is used for the chamber of a process vessel of the plasma apparatus that generally performs the processing under a high degree of reduced pressure, it takes a very long time to reach a predetermined degree of the reduced pressure. This is a phenomenon prominently seen at the start-up time of the apparatus.

This is because the oxide coating film formed on the surface of the anodically oxidized aluminum alloy is inherently porous and thus has a problem of outgas and includes pores formed and remaining therein, so that it takes an excessively long time for vacuuming to the predetermined degree of reduced pressure.

### Disclosure of the Invention

The present invention was made in consideration of these respects, and its object is to realize the formation of a coating film that is denser and has a more improved corrosion resistance than a conventional coating film, on various kinds of members used in a plasma processing apparatus and a processing apparatus, such as chambers of these processing apparatuses, and further on the apparatuses themselves. It is another object to provide a method of plasma processing suitable for forming such a coating film.

In order to achieve the objects stated above, a member of a plasma processing apparatus of the present invention is a member which is used in a plasma processing apparatus applying plasma processing and at least part of which is exposed to plasma, the member being made of aluminum or an aluminum alloy and including an oxide coating film on a surface of the part exposed to the plasma, and the oxide coating film being formed through oxidation by plasma processing.

A possible example of the oxide coating film formed through the oxidation by the plasma processing is an oxide coating film formed through oxidation by, for example, an oxygen radical generated by plasma.

According to findings by the inventors, an oxide coating film formed on a surface of aluminum or an aluminum alloy by plasma processing, for example, by an oxygen radical generated by plasma, has properties of being extremely dense and having a flat surface, and few pore exists in the film. Further, it has been found out that the abovementioned oxide coating film is strong and has improved corrosion resistance. Therefore, a member having such a coating film is very much suitable as a member exposed to the plasma. When the member having undergone such processing is used as a constituent member of a chamber of various kinds of pressure-reduced apparatuses, such as a process vessel of a plasma processing apparatus, it is possible to shorten the time required for vacuuming to a predetermined degree of reduced pressure, compared with the time conventionally required. The oxidation by the oxygen radical, which will be described later, is realized by, for example, turning oxygen-containing gas into plasma to thereby apply the plasma processing to the surface of the aluminum or aluminum alloy.

Examples of the member as the object of the present invention are, besides the aforesaid chamber, a mounting table to place a substrate thereon, an electrode, a gate valve, and an exhaust pipe used for exhausting the inside of the chamber.

A member of a plasma processing apparatus of the present invention may be a member made of aluminum or an aluminum alloy and including an oxide coating film of aluminum or an aluminum alloy on a surface of a part exposed to plasma, the oxide coating film containing a minute amount of a rare gas component. When the rare gas is contained, a film stress is alleviated and adhesiveness and reliability are improved. As the rare gas, krypton (Kr) gas is especially preferable.

According to another aspect, a member of a plasma processing apparatus of the present invention may be a member made of an aluminum alloy containing, besides aluminum, at least one of magnesium, strontium, and barium, and including an oxide coating film on a part exposed to plasma, wherein the oxide coating film includes an aluminum oxide and at least one of a magnesium oxide, a strontium oxide, and a barium oxide. The member of the plasma processing apparatus described above has a further improved corrosion resistance.

The aluminum alloy may contain at least zirconium, or contain at least hafnium. When either of them is contained, mechanical strength is improved.

Furthermore, a content ratio of each of Fe, Mn, Cr, and Zn in the aluminum alloy is preferably 0.01 weight % or less. This is because containing a large amount of any of these metals leads to deterioration in the corrosion resistance.

Because of the above-described properties of the oxide coating film, it is also possible to propose a member which is used in a processing apparatus applying processing to a processing target in a process vessel by using a highly reactive gas or chemical solution and at least part of which is exposed to the gas or chemical solution.

Specifically, a member of a processing apparatus of the present invention is a member which is used in a processing apparatus applying processing to a processing target in a process vessel by using a highly reactive gas or chemical solution and at least part of which is exposed to the gas or chemical solution, the member being made of aluminum or an aluminum alloy and including an oxide coating film on a surface of the part exposed to the gas or chemical solution, and the oxide coating film being formed through oxidation by plasma processing.

A possible example of the oxide coating film formed through the oxidation by the plasma processing is an oxide coating film formed through oxidation by, for example, an oxygen radical generated by plasma.

Possible examples of the highly reactive gas or chemical solution are Chlorine gas, Fluorine gas, HCl, $H_2SO_4$, and HF. Further, besides the aforementioned chamber, mounting table, and gate valve, possible examples of the member exposed to the gas or chemical solution are a chemical solution tank, various pipes such as a supply pipe and an exhaust pipe, a member (for example, a blade) of a pump for exhaust, and a valve.

Examples of the processing apparatus are those used in manufacturing electronics devices such as a semiconductor device and a liquid crystal display device, and include: processing apparatuses such as an etching apparatus, a deposition apparatus, other electronic device manufacturing apparatuses in general, a cleaning apparatus using a chemical solution for cleaning, and various kinds of heating apparatuses; and a plasma processing apparatus applying plasma processing by generating plasma.

Further, a member of a processing apparatus of the present invention may be a member made of aluminum or an aluminum alloy and including an oxide coating film of aluminum or an aluminum alloy on a surface of a part exposed to plasma, the oxide coating film containing a minute amount of a rare gas component.

As previously described, when the rare gas is contained, a film stress is alleviated and adhesiveness and reliability are improved. Krypton (Kr) gas is preferable as the rare gas.

Furthermore, a member of a processing apparatus of the present invention may be a member made of an aluminum alloy containing, besides aluminum, at least one of magnesium, strontium, and barium, and including an oxide coating film on a surface of a part exposed to plasma, wherein the oxide coating film includes an aluminum oxide and at least one of a magnesium oxide, a strontium oxide, and a barium oxide. Such composition achieves further improvement in the corrosion resistance.

The aluminum alloy may contain at least zirconium, or contain at least hafnium. When either of them is contained, mechanical strength is improved.

Furthermore, a content ratio of each of Fe, Mn, Cr, and Zn in the aluminum alloy is preferably 0.01 weight % or less. This is because containing a large amount of any of these metals leads to deterioration in the corrosion resistance.

A plasma processing apparatus of the present invention is a plasma processing apparatus applying plasma processing to a substrate in a process vessel, the apparatus including a member which is exposed to plasma and at least part of which is made of aluminum or an aluminum alloy and includes an oxide coating film on a surface of the aluminum or aluminum alloy, the oxide coating film being formed through oxidation by plasma processing.

A possible example of the oxide coating film formed through the oxidation by the plasma processing is an oxide coating film formed through oxidation by, for example, an oxygen radical generated by plasma.

According to another aspect, the present invention is a plasma processing apparatus applying plasma processing to a substrate in a process vessel, the apparatus including a member which is exposed to plasma and at least part of which is made of aluminum or an aluminum alloy and comprises an oxide coating film of aluminum or an aluminum alloy on a surface of the aluminum or aluminum alloy, the oxide coating film containing a minute amount of a rare gas component. As the rare gas, krypton (Kr) gas is preferable.

According to another aspect, the present invention is a plasma processing apparatus applying plasma processing to a substrate in a process vessel, the apparatus including a member which is exposed to plasma and at least part of which is made of an aluminum alloy containing, besides aluminum, at least one of magnesium, strontium, and barium, and includes an oxide coating film on a surface of the aluminum alloy, wherein the oxide coating film includes an aluminum oxide and at least one of a magnesium oxide, a strontium oxide, and a barium oxide.

The aluminum alloy may contain at least zirconium, or contain at least hafnium. When either of them is contained, mechanical strength is improved.

A content ratio of each of Fe, Mn, Cr, and Zn in the aluminum alloy is preferably 0.01 weight % or less. This is because containing a large amount of any of these metals leads to deterioration in the corrosion resistance.

According to yet another aspect, the present invention is a processing apparatus applying processing to a processing target in a process vessel by using highly reactive gas or chemical solution, the apparatus including a member which is exposed to the gas or chemical solution and at least part of which is made of aluminum or an aluminum alloy and includes an oxide coating film on a surface of the aluminum or aluminum alloy, the oxide coating film being formed through oxidation by plasma processing.

A possible example of the oxide coating film formed through the oxidation by the plasma processing is an oxide coating film formed through oxidation by, for example, an oxygen radical generated by plasma.

At least part of the member which is exposed to the gas or chemical solution may be made of aluminum or an aluminum alloy and may include an oxide coating film of aluminum or an aluminum alloy on a surface of the aluminum or aluminum alloy, the oxide coating film containing a minute amount of a rare gas component. As the rare gas, krypton (Kr) gas is preferable.

Furthermore, at least part of the member which is exposed to the gas or chemical solution may be made of an aluminum alloy containing at least one of magnesium, strontium, and barium, and may include an oxide coating film on a surface of the aluminum alloy, wherein the oxide coating film includes an aluminum oxide and at least one of a magnesium oxide, a strontium oxide, and a barium oxide.

The aluminum alloy may contain at least zirconium, or contain at least hafnium. When either of them is contained, mechanical strength is improved.

A content ratio of each of Fe, Mn, Cr, and Zn in the aluminum alloy is 0.01 weight % or less. This is because containing a large amount of any of these metals leads to deterioration in the corrosion resistance.

A method of plasma processing of the present invention is a method for applying plasma processing to a processing target in a process vessel, the method comprising the step of, while keeping a temperature of the processing target made of aluminum or an aluminum alloy in the process vessel at 450°C or lower, applying oxidation processing to a surface of the processing target in the process vessel by an oxygen radical generated by plasma.

According to findings by the inventors, when plasma was generated by using, for example, krypton-containing oxygen gas, it was possible to apply suitable oxidation processing to a processing target made of aluminum or an aluminum alloy, by an oxygen radical generated by the plasma even when the processing target was kept at room temperature (for example, 23°C), and as a result, it was possible to form, on a surface of the processing target, a coating film of $Al_2O_3$ which was extremely dense without any pore and whose surface was flat.

This is because the reformation of the surface of the aluminum or aluminum alloy was promoted by the oxygen radical as shown by the expression below.

$$2Al + 3O^* \rightarrow Al_2O_3$$

According to another aspect of the present invention, a method of plasma processing of the present invention includes the steps of: heating the processing target made of aluminum or an aluminum alloy in the process vessel to a temperature of 150°C to 250°C; and applying oxidation processing to a surface of the processing target in the process vessel by an oxygen radical generated by plasma.

According to findings by the inventors, when a processing target made of aluminum or an aluminum alloy was heated to the temperature of 150°C to 250C° and oxidation processing was applied to the processing target in a process vessel, by an oxygen radical generated by plasma, it was also possible to form a coating film of $Al_2O_3$ which was extremely dense without any pore and whose surface was flat, when oxygen gas containing rare gas other than krypton was turned into plasma.

When an aluminum alloy containing magnesium (Mg) is used as the aforesaid aluminum alloy, an oxide coating film containing a large amount of MgO produced by an oxygen radical can be formed on a surface of the aluminum alloy. Therefore, it is possible to provide a material with improved corrosion resistance and strength. An appropriate content ratio of the magnesium is 0.5 weight % to solubility limit (the inventors think that it is about 6.0 weight %).

Incidentally, when krypton-containing oxygen gas is turned into plasma to generate an oxygen radical, it is possible to obtain MgO by oxidizing magnesium, even if the content ratio of the magnesium is extremely low such as 0.5 weight % or 1.0 weight %.

When an aluminum alloy containing strontium (Sr) is used as the aforesaid aluminum alloy, an oxide coating film containing a large amount of SrO produced through the oxidation by an oxygen radical can be formed on a surface of the aluminum alloy, so that it is possible to provide a material with improved corrosion resistance and strength.

When an aluminum alloy containing barium (Ba) is used as the aforesaid aluminum alloy, an oxide coating film containing a large amount of BaO produced through the oxidation by an oxygen radical can be formed on a surface of the aluminum alloy, so that it is possible to provide a material with improved corrosion resistance and strength.

When an aluminum alloy containing zirconium (Zr) is used as the aforesaid aluminum alloy, grain growth of the alloy can be suppressed, so that it is possible to provide a material with improved corrosion resistance and strength. A content ratio of about 0.1 to 0.15 weight % is thought to be sufficient.

When an aluminum alloy containing hafnium (Hf) is used as the aforesaid aluminum alloy, grain growth of the alloy can be suppressed, so that it is possible to provide a material with improved corrosion resistance and strength. A content ratio of about 0.1 to 0.15 weight % is thought to be sufficient.

Furthermore, a content ratio of each of Fe, Mn, Cr, and Zn in the aluminum alloy is preferably 0.01 weight % or less. This is because containing a large amount of any of these metals leads to deterioration in the corrosion resistance.

From this viewpoint, Fe, Mn, Cr, and Zn can be removed from the processing target if the processing target of the aluminum alloy undergoes pre-processing while being set at 450°C or lower in a hydrogen reducing atmosphere before the oxidation processing is applied thereto.

In generating the oxygen radical by the plasma, gas in which krypton (Kr) gas is mixed in oxygen-containing gas may be used to generate the plasma. Mixing the krypton gas makes it possible to easily generate two oxygen radicals since krypton excited to a high energy state collides with an oxygen molecule ($O_2$), and as a result, a large amount of the oxygen radical can be generated in a short time, which enables improvement in the oxidation rate.

Moreover, the processing target can be suitably oxidized even when the temperature thereof is room temperature.

In generating the oxygen radical, gas in which argon (Ar) gas is mixed in oxygen-containing gas may be used to generate plasma. Since the argon gas is easy to handle and is inexpensive, these merits can be enjoyed when they are in practical use.

Further, when the oxidation processing is applied by generating plasma using rare gas such as krypton or argon, for example, when the oxidation processing by an oxygen radical is applied, a produced oxide contains a minute amount of a component of this rare gas. Accordingly, a film stress of the coating film is suppressed and adhesiveness and reliability thereof are improved.

Though a plasma source used for generating the oxygen radical is not limited to a specific one, plasma generated by a microwave having a frequency of 2.45 GHz is an example suitable for the present invention. The microwave plasma is, so to speak, moderate plasma, being high in density and relatively low in Vdc, and therefore, it is possible to suitably apply radical oxidation processing to the surface of the processing target to form the oxide coating film, without giving any damage to the surface of the aluminum or aluminum alloy.

The oxidation processing, according to the present invention, by the oxygen radical to the processing target having the aluminum or aluminum alloy surface may be performed until the oxide coating film with a desired thickness is formed, but it can be proposed that, for example, the oxidation processing be performed up to a so-called saturation state in which the oxygen radical no longer reacts with the surface of the processing target, resulting in no growth of the coating film. When the processing target processed up to this state is used as, for example, a chamber wall of a plasma processing apparatus, and then oxidation processing, film deposition processing, or the like is applied to a semiconductor wafer or the like by the plasma processing apparatus, it is possible to prevent the oxygen radical necessary for the processing from reacting with the inner wall of the chamber. As a result, feed efficiency of the oxygen radical into the semiconductor wafer or the like is improved, enabling high-rate processing.

Brief Description of the Drawings

Fig. 1 is a vertical cross-sectional view of a plasma processing apparatus for implementing an embodiment of the present invention;

Fig. 2 is a graph showing a depth profile of $Al_2O_3$ - Al of a processing target before undergoing oxidation processing;

Fig. 3 is a graph showing a depth profile of $Al_2O_3$ - Al when the oxidation processing is applied to the processing target at room temperature by an oxygen radical;

Fig. 4 is a graph showing a depth profile of $Al_2O_3$ - Al when the oxidation processing is applied to the processing target at 200°C by the oxygen radical;

Fig. 5 is a graph showing a depth profile of MgO - Mg of the processing target before undergoing the oxidation processing;

Fig. 6 is a graph showing a depth profile of MgO - Mg when the oxidation processing is applied to the processing target at room temperature by the oxygen radical;

Fig. 7 is a graph showing a depth profile of MgO - Mg when the oxidation processing is applied to the processing target at 200°C by the oxygen radical;

Fig. 8 is a graph showing an XPS depth profile when oxidation processing is applied to a processing target at 25°C by an oxygen radical of krypton-containing gas;

Fig. 9 is a graph showing an XPS depth profile when oxidation processing by an oxygen radical of argon-containing gas is applied to a processing target at 200°C whose magnesium content ratio is 2.5 weight %;

Fig. 10 is a graph showing an XPS depth profile when the oxidation processing by the oxygen radical of the argon-containing gas is applied to a processing target at 200°C whose magnesium content ratio is 4.5 weight %;

Fig. 11 is a graph showing an XPS depth profile of a processing target whose magnesium content ratio is 1.0 weight % before the processing target undergoes processing;

Fig. 12 is a graph showing a XPS depth profile when the oxidation processing by an oxygen radical of krypton-containing gas is applied to the processing target at 200°C whose magnesium content ratio is 1.0 weight %;

Fig. 13 is a graph showing an XPS depth profile when the oxidation processing by the oxygen radical of the krypton-containing gas is applied to a processing target at 200°C whose magnesium content ratio is 2.5 weight %; and

Fig. 14 is a graph showing an XPS depth profile when the oxidation processing by the oxygen radical of the krypton-containing gas is applied to a processing target at 200°C whose magnesium content ratio is 4.5 weight %.

Best Mode for Carrying out the Invention

Hereinafter, embodiments of the present invention will be described. Fig. 1 schematically shows the appearance of a vertical cross section of a plasma processing apparatus 1 used for carrying out a method of the present invention, and this plasma processing apparatus 1 includes a process vessel 2 made of, for example, an aluminum alloy and having a bottomed cylindrical shape with an upper portion being open. The process vessel 2 is grounded. In a bottom portion of the process vessel 2, a susceptor 3 to place, for example, a semiconductor wafer (hereinafter, referred to as a wafer) W thereon is provided. This susceptor 3 is made of, for example, an aluminum alloy, and when power is supplied thereto from an AC power source 4 provided outside the process vessel 2, a heater 5 in the susceptor 3 generates heat, so that it is possible to heat a substrate, a sample, or a processing target on the susceptor 3 to about 300°C.

In the bottom portion of the process vessel 2, provided is an exhaust pipe 12 through which an atmosphere in the process vessel 2 is exhausted by an exhaust device 11 such as a turbo molecular pump. The process vessel 2 further has, in a sidewall thereof, a supply pipe 14 through which process gas from a process gas supply source 13 is supplied. In this embodiment, supply sources 15, 16 of oxygen gas ($O_2$) and argon (Ar) gas being inert gas are connected to the process gas supply source 13.

A dielectric window 22 made of, for example, quartz glass is provided on an opening of the upper portion of the process vessel 2 via a sealing member 21 such as an O-ring for ensuring airtightness. A process space S is formed in the process vessel 2 by this dielectric window 22.

On an upper side of the dielectric window 22, an antenna member 31 is provided. In this embodiment, the antenna member 31 is constituted of, for example, a radial slot antenna 32 positioned on a lowest surface, a retardation plate 33 positioned on an upper side thereof, and an antenna cover 34 covering the retardation plate 33 to protect it and cooling the retardation plate 33.

The radial slot antenna 32 is made of a thin disc of a conductive material, for example, copper, and pairs of slits are formed in the disc to be arranged coaxially, the slits in each pair making an acute angle approximate to a right angle.

The retardation plate 33 has at a center thereof a bump 35 constituting part of a conical shape and made of a conductive material, for example, metal. The bump 35 is electrically connected to an inner conductor 36a of a coaxial waveguide 36 which is constituted of the inner conductor 36a and an outer pipe 36b. The coaxial waveguide 36 guides a microwave of, for example, 2.45 GHz generated in a microwave supply device 37 so that the microwave propagates to the antenna member 31 through a load matching device 38 and the coaxial waveguide 36.

The plasma processing apparatus 1 has the above-described configuration, and next, a method of plasma processing according to an embodiment of the present invention will be described.

Each of processing targets T used in this embodiment is made of a thin-plate aluminum alloy in a rectangular shape and they are arranged in a radial direction and pasted on a surface of the wafer W placed on the susceptor 3. This aluminum alloy contains 2.5 weight % magnesium.

The heater 5 when in operation is capable of heating the processing target T pasted on the wafer W on the susceptor 3 to temperatures in a range from room temperature to about 300°C and maintaining the raised temperature. By this operation, the temperature of the processing target T was maintained at a predetermined temperature. Then, the inside of the process vessel 2 was exhausted through the exhaust pipe 12 while predetermined mixed gas of oxygen and argon was being supplied thereto from the supply pipe 14 so that the inside of the process space S came to have a predetermined pressure, and then the microwave was generated by the microwave supply device 37 to be propagated to the antenna member 31 by the coaxial waveguide 36, so that plasma was generated in the process space S, and by an oxygen radical generated in the process vessel 2 by the plasma, oxidation processing was applied to a surface of the processing target T.

The plasma conditions for the oxidation processing are as follows.

- gas: 1% $O_2$/Ar
- pressure: 133 Pa (1 Torr)
- microwave output: 2 kW
- plasma irradiation time: 10 min.

- the temperature of the processing target: room temperature to 200°C

Results of the oxidation processing will be described based on Fig. 2 to Fig. 7. Graphs in the respective drawings show the results of analyzing the composition in a depth direction of the processing target T by plasma etching using $NF_3$/Ar gas, and the calibrations on the left of the vertical axis show the etching time, which represents the depth. 10 min is equivalent to about 40 nm.

(1) First, a depth profile of $Al_2O_3$ - Al of the processing target T before undergoing the oxidation processing is as shown in Fig. 2.
(2) A depth profile of $Al_2O_3$ - Al when the oxidation processing by the oxygen radical is applied to the processing target T that is not heated but kept at room temperature (about 23°C) is shown in Fig. 3.
(3) A depth profile of $Al_2O_3$ - Al when the oxidation processing by the oxygen radical is applied to the processing target T heated to 200°C is shown in Fig. 4.

As is apparent from the experiment results shown in the drawings, $Al_2O_3$ is initially formed through natural oxidation up to a depth of about 15 nm on the surface of the processing target T before the oxidation processing, but Al being a base material still remains at a further deeper portion.

Next, as shown in Fig. 3, even when the processing target T kept at room temperature is subjected to the oxidation processing by the oxygen radical, $Al_2O_3$ is formed up to only a slightly deeper portion compared with that of the unprocessed processing target T, but Al being the base material still remains at a further deeper portion.

On the other hand, when the processing target T heated to 200°C is subjected to the oxidation processing, $Al_2O_3$ is formed entirely up to an examined 40 nm depth, and no Al being the base material is observed, as shown in Fig. 4.

Therefore, it is possible to form a considerably thick coating film of $Al_2O_3$ when the processing target T is heated to 200°C and is subjected to the oxygen radical processing. Moreover, the formed coating film itself can be a denser coating film without any pore and with a flatter surface, compared with that formed by anodic oxidation processing as is conventionally practiced.

Next, depth profiles of MgO - Mg of the processing target T will be described based on Fig. 5 to Fig. 7.

(1) The depth profile of MgO - Mg of the processing target T before undergoing the oxidation processing is as shown in Fig. 5.
(2) The depth profile of MgO - Mg when the oxidation processing by the oxygen radical is applied to the processing target T that is not heated but kept at room temperature (about 23°C) is as shown in Fig. 6.
(3) The depth profile of MgO - Mg when the oxidation processing by the oxygen radical is applied to the processing target T heated to 200°C is as shown in Fig. 7.

As is apparent from the above results, first as shown in Fig. 5, MgO produced through the oxidation is not observed on the surface of the processing target T before undergoing the oxidation processing, and pure Mg begins to appear from about a 25 nm depth.

Next, as shown in Fig. 6, it is seen that, when the processing target T kept at room temperature is subjected to the oxidation processing by the oxygen radical, MgO is formed at a depth of about 20 nm or less, but there still remains the pure Mg.

On the other hand, when the processing target heated to 200°C is subjected to the oxidation processing by the oxygen radical, MgO is formed entirely up to an examined 40 nm depth and no pure Mg is observed, as shown in Fig. 7.

Therefore, it is possible to form a large amount of MgO in the aforesaid $Al_2O_3$ coating film if the processing target T is heated to 200°C and is subjected to the oxidation processing by the oxygen radical.

The existence of a large amount of MgO in the $Al_2O_3$ coating film verifies that the coating film is accordingly a strong and a highly corrosion-resistant coating film.

In the aforesaid example, the processing target was heated to the temperature of 200°C, but the inventors think that the same effect can be obtained when the temperature range is 200°C ± 50°C, namely, the range of 150°C to 250°C. If the processing target is aluminum or an aluminum alloy, the same effect is also obtained when the processing is applied at a temperature lower than a temperature at which these metals soften (450°C).

Incidentally, as previously described, the use of krypton-containing gas in generating the oxygen radical makes it possible to form a suitable oxide coating film by oxidizing the surface of the processing target even when the temperature thereof is room temperature.

Fig. 8 shows an XPS depth profile when the processing target T containing 4.5 weight % magnesium and set at the temperature of 25°C is radical-oxidized by using the aforesaid plasma processing apparatus 1. In the graph in this drawing, the horizontal axis shows film thickness (0 represents the surface) and the vertical axis shows the content ratio (at %) of each component.

Note that the plasma conditions for the oxidation processing are as follows.

- gas: 1% $O_2$/Kr
- pressure: 133 Pa (1 Torr)

- microwave output: 2 kW
- plasma irradiation time: 10 min.
- the temperature of the processing target: 25°C

As is apparent from the result, even when the temperature of the processing target T was room temperature, namely, 25°C, it was possible to condense magnesium up to 30 at % and to oxidize this on the surface. Further, as for the film thickness, it was possible to form $Al_2O_3$ up to an 80 nm depth and moreover, to have the coating film contain a large amount of MgO.

In this example, the processing target T containing 4.5 weight % magnesium was processed, but as for processing targets containing magnesium whose content ratios are 1.0 weight % and 2.5 weight %, the use of krypton-containing gas in generating the oxygen radical makes it possible to form a suitable oxidation coating film by oxidizing the surface of each of the processing targets even when the temperature of each of the processing targets is room temperature.

Further, in the aforesaid embodiment using the argon-containing gas, the processing target T made of the aluminum alloy whose magnesium content ratio was 2.5 weight % was used, but according to findings by the inventors, a significantly prominent effect was not obtained when this content ratio was 1.0 weight%. Therefore, it is thought that desired MgO cannot be produced unless a certain amount of magnesium is contained, and it is also thought that the larger this amount is, the larger amount of MgO can be produced in the coating film.

When processing targets each of which was made of an aluminum alloy and whose magnesium content ratios were, for example, 2.5 weight % and 4.5 weight % respectively were subjected to oxidation processing by using argon-containing gas, XPS depth profiles as shown in Fig. 9 and Fig. 10 were obtained, respectively. Note that the plasma conditions are as follows.

- gas: 1% $O_2$/Ar
- pressure: 133 Pa (1 Torr)
- microwave output: 2 kW
- plasma irradiation time: 10 min.
- the temperature of the processing targets: 200°C

It is seen from the results that a larger amount of MgO is produced in a coating film of the processing target whose magnesium content ratio is 4.5 weight % than in a coating film of the processing target whose magnesium content ratio is 2.5 weight %.

However, when krypton-containing gas was used to generate an oxygen radical and oxidation processing was applied by this, it was possible to produce MgO even if the magnesium content ratio was 1.0 weight %.

Fig. 11 shows an XPS depth profile of a processing target whose magnesium content ratio is 1.0 weight %, before the processing target undergoes the processing, and Fig. 12 shows an XPS depth profile after the processing target whose magnesium content ratio is 1.0 weight % is subjected to the radical oxidation processing. Note that the plasma conditions for the oxidation processing are as follows.

- gas: 1% $O_2$/Kr
- pressure: 133 Pa (1 Torr)
- microwave output: 2 kW
- plasma irradiation time: 10 min.
- the temperature of the processing target: 200°C

As is seen from the result, even for the processing target whose magnesium content ratio was 1.0 weight %, it was possible to condense magnesium up to about 30 at % and oxidize this even on the surface of the processing target when the krypton-containing gas was used to generate an oxygen radical and the oxidation processing was applied. Therefore, it can be confirmed that highly corrosion-resistant MgO is formed on the surface.

Naturally, when the krypton-containing gas is used to generate the oxygen radical for the oxidation processing, the higher the magnesium content ratio of the processing target of the aluminum alloy is, the larger amount of MgO can be generated and in addition, up to the deeper position in the coating film this MgO can exist.

Fig. 13 shows an XPS depth profile when a processing target whose magnesium content ratio is 2.5 weight % is subjected to oxidation processing by generating an oxygen radical by the krypton-containing gas, and Fig. 14 shows an XPS depth profile when a processing target whose magnesium content ratio is similarly 2.5 weight % is subjected to the oxidation processing.

As is seen from the results, the higher the magnesium content ratio is, the larger amount of MgO can be produced and up to the deeper position in the coating film MgO can exist. In the both cases, it was possible to condense the magnesium on the surface up to 30 at %.

As described above, an appropriate magnesium content ratio in the aluminum alloy adoptable in the present invention is thought to be, for example, 0.5 weight % to the solubility limit, more preferably, 1.0 weight % to the solubility limit.

As described above, when the oxidation processing by the oxygen radical is applied to the processing target made of the aluminum alloy by the method of plasma processing according to the present invention, it is possible to form on the surface thereof a highly corrosion-resistant oxide coating film with a considerably large thickness. Therefore, in view of these respects, when a member whose surface has been subj ected to the oxidation processing of the oxygen radical by the aforesaid plasma processing is used as a member exposed to plasma in the aforesaid plasma processing apparatus 1, for example, an inner wall and the susceptor of the process vessel 2, the exhaust pipe 12 and the supply pipe 14, and further, a not-shown gate valve through which the wafer is carried in/out, it is possible to provide a plasma apparatus that is extremely durable and in which the time for vacuuming up to a predetermined degree of reduced pressure is shortened.

Of course, if the member whose surface has been subjected to the oxidation processing of the oxygen radical by the aforesaid plasma processing is used not only as such members around the process vessel 2 but also as members in contact with corrosive gas generated in the process vessel, it is possible to improve durability of these members.

Further, from a different viewpoint, in the case where the member subjected to the oxidation processing of the oxygen radical by the plasma processing according to the present invention is used as such members around the process vessel, the use of the member to which the oxidation processing is applied to a saturation state (a state where no film growth is observed) can prevent the oxygen radical, which is to be fed into a portion of a wafer or a semiconductor element, from oxidizing the chamber or the gate valve of the process vessel and thus being consumed in, for example, executing semiconductor manufacturing processes such as etching processing and film deposition processing, if this processing uses the oxygen radical. That is, it is possible to prevent a state in which the number of oxygen radicals decreases to lower the processing rate being a primarily important factor.

Therefore, the use of the member subjected to the plasma processing of the present invention as a constituent material of, typically, a process vessel of a processing apparatus makes it possible not only to improve durability but also to improve the processing rate itself being a primarily important factor.

Incidentally, even when a member not subjected to the oxidation processing up to such a saturation state (for example, a chamber wall and a susceptor) is used, if the apparatus is operated at a temperature equal to or lower than a temperature for the oxidation processing (for example, 150°C to 450°C, preferably 150°C to 250°C), the oxygen radical generated for the processing in the semiconductor processes does not react with surfaces of these members and thus is not uselessly consumed.

Incidentally, in the examples described above, the wavelength of the microwave is 2.45 GHz, but this is not of course restrictive, and the present invention is applicable to microwaves with various frequencies. Further, the plasma source itself is not limited to the microwave, but various plasma sources using a high frequency of, for example, 13.56 MHz are usable.

Further, the oxide coating film according to the present invention is effectively used for portions other than the portion exposed to the plasma. That is, the application of the present invention is not limited to the plasma processing apparatus, but it is applicable not only to the plasma processing apparatus but also to members of portions exposed to highly reactive and corrosive gas (for example, Chlorine gas, Fluorine gas, or the like) or a highly reactive and corrosive chemical solution (HCl, $H_2SO_4$, HF, or the like) in processing apparatuses used in manufacturing electronic devices such as a semiconductor device and a liquid crystal device, for example, in an etching apparatus, a deposition apparatus, other electronic device manufacturing apparatuses in general, a cleaning apparatus using a chemical solution for cleaning, and various kinds of heating apparatuses. The use of the member of aluminum or its alloy in these electronic device manufacturing devices and so on is preferable in view of reducing the weight of the apparatuses, and by coating the surface of the member with the coating film according to the present invention, it is possible to flatten the surface of the member and to improve its corrosion resistance and durability.

According to the present invention, a denser coating film having a flatter surface is formed and the corrosion resistance is made higher than when the conventional anodic oxidation processing is applied.

Industrial Applicability

The present invention is extremely effective for improving the corrosion resistance of various kinds of members such as a chamber using aluminum or an aluminum alloy in various kinds of processing apparatuses such as a plasma processing apparatus.

## Claims

**1.** A member of a plasma processing apparatus which is used in a plasma processing apparatus applying plasma processing and at least part of which is exposed to plasma,
the member being made of aluminum or an aluminum alloy and comprising an oxide coating film on a surface of the part exposed to the plasma, and the oxide coating film being formed through oxidation by plasma processing.

**2.** A member of a plasma processing apparatus which is used in a plasma processing apparatus applying plasma processing and at least part of which is exposed to plasma,
the member being made of aluminum or an aluminum alloy and comprising an oxide coating film on a surface of the part exposed to the plasma, and the oxide coating film being formed through oxidation by an oxygen radical.

**3.** A member of a plasma processing apparatus which is used in a plasma processing apparatus applying plasma processing and at least part of which is exposed to plasma,
the member being made of aluminum or an aluminum alloy and comprising an oxide coating film of aluminum or an aluminum alloy on a surface of the part exposed to the plasma, and the oxide coating film containing a minute amount of a rare gas component.

**4.** The member of the plasma processing apparatus according to claim 3,
wherein the rare gas component is krypton.

**5.** A member of a plasma processing apparatus which is used in a plasma processing apparatus applying plasma processing and at least part of which is exposed to plasma,
the member being made of an aluminum alloy containing at least one of magnesium, strontium, and barium, and comprising an oxide coating film on the part exposed to the plasma,
wherein said oxide coating film includes an aluminum oxide and at least one of a magnesium oxide, a strontium oxide, and a barium oxide.

**6.** The member of the plasma processing apparatus according to claim 1,
wherein said aluminum alloy contains at least zirconium.

**7.** The member of the plasma processing apparatus according to claim 1,
wherein said aluminum alloy contains at least hafnium.

**8.** The member of the plasma processing apparatus according to claim 1,
wherein a content ratio of each of Fe, Mn, Cr, and Zn in said aluminum alloy is 0.01 weight % or less.

**9.** A member of a processing apparatus which is used in a processing apparatus applying processing to a processing target in a process vessel by using a highly reactive gas or chemical solution and at least part of which is exposed to the gas or chemical solution,
the member being made of aluminum or an aluminum alloy and comprising an oxide coating film on a surface of the part exposed to the gas or chemical solution, and the oxide coating film being formed through oxidation by plasma processing.

**10.** A member of a processing apparatus which is used in a processing apparatus applying processing to a processing target in a process vessel by using a highly reactive gas or chemical solution and at least part of which is exposed to the gas or chemical solution,
the member being made of aluminum or an aluminum alloy and comprising an oxide coating film on a surface of the part exposed to the gas or chemical solution, and the oxide coating film being formed through oxidation by an oxygen radical.

**11.** A member of a processing apparatus which is used in a processing apparatus applying processing to a processing target in a process vessel by using a highly reactive gas or chemical solution and at least part of which is exposed to the gas or chemical solution,
the member being made of aluminum or an aluminum alloy and comprising an oxide coating film of aluminum or an aluminum alloy on a surface of the part exposed to the gas or chemical solution, and the oxide coating film containing a minute amount of a rare gas component.

**12.** The member of the processing apparatus according to claim 11,
wherein the rare gas component is krypton.

**13.** A member of a processing apparatus which is used in a processing apparatus applying processing to a processing target in a process vessel by using a highly reactive gas or chemical solution and at least part of which is exposed to the gas or chemical solution,
the member being made of an aluminum alloy containing at least one of magnesium, strontium, and barium, and comprising an oxide coating film on a surface of the part exposed to the gas or chemical solution,
wherein said oxide coating film includes an aluminum oxide and at least one of a magnesium oxide, a strontium oxide, and a barium oxide.

**14.** The member of the processing apparatus according to claim 9,
wherein said aluminum alloy contains at least zirconium.

**15.** The member of the processing apparatus according to claim 9,
wherein said aluminum alloy contains at least hafnium.

**16.** The member of the processing apparatus according to claim 9,
wherein a content ratio of each of Fe, Mn, Cr, and Zn in said aluminum alloy is 0.01 weight % or less.

**17.** A plasma processing apparatus applying plasma processing to a substrate in a process vessel, the apparatus comprising
a member which is exposed to plasma and at least part of which is made of aluminum or an aluminum alloy and comprises an oxide coating film on a surface of said aluminum or aluminum alloy, the oxide coating film being formed through oxidation by plasma processing.

**18.** A plasma processing apparatus applying plasma processing to a substrate in a process vessel, the apparatus comprising

a member which is exposed to plasma and at least part of which is made of aluminum or an aluminum alloy and comprises an oxide coating film on a surface of said aluminum or aluminum alloy, the oxide coating film being formed through oxidation by an oxygen radical.

**19.** A plasma processing apparatus applying plasma processing to a substrate in a process vessel, the apparatus comprising

a member which is exposed to plasma and at least part of which is made of aluminum or an aluminum alloy and comprises an oxide coating film on a surface of said aluminum or aluminum alloy, the oxide coating film containing a minute amount of a rare gas component.

**20.** The plasma processing apparatus according to claim 19,

wherein the rare gas component is krypton.

**21.** A plasma processing apparatus applying plasma processing to a substrate in a process vessel, the apparatus comprising

a member which is exposed to plasma and at least part of which is made of an aluminum alloy containing at least one of magnesium, strontium, and barium, and comprises an oxide coating film on a surface of said aluminum alloy,

wherein said oxide coating film includes an aluminum oxide and at least one of a magnesium oxide, a strontium oxide, and a barium oxide.

**22.** The plasma processing apparatus according to claim 17,

wherein said aluminum alloy contains at least zirconium.

**23.** The plasma processing apparatus according to claim 17,

wherein said aluminum alloy contains at least hafnium.

**24.** The plasma processing apparatus according to claim 17,

wherein a content ratio of each of Fe, Mn, Cr, and Zn in said aluminum alloy is 0.01 weight % or less.

**25.** A processing apparatus applying processing to a processing target in a process vessel by using highly reactive gas or chemical solution, the apparatus comprising

a member which is exposed to the gas or chemical solution and at least part of which is made of aluminum or an aluminum alloy and comprises an oxide coating film on a surface of said aluminum or aluminum alloy, the oxide coating film being formed through oxidation by plasma processing.

**26.** A processing apparatus applying processing to a processing target in a process vessel by using highly reactive gas or chemical solution, the apparatus comprising

a member which is exposed to the gas or chemical solution and at least part of which is made of aluminum or an aluminum alloy and comprises an oxide coating film on a surface of said aluminum or aluminum alloy, the oxide coating film being formed through oxidation by an oxygen radical.

**27.** A processing apparatus applying processing to a processing target in a process vessel by using highly reactive gas or chemical solution, the apparatus comprising

a member which is exposed to the gas or chemical solution and at least part of which is made of aluminum or an aluminum alloy and comprises an oxide coating film of aluminum or an aluminum alloy on a surface of said aluminum or aluminum alloy, the oxide coating film containing a minute amount of a rare gas component.

**28.** The processing apparatus according to claim 27,

wherein the rare gas component is krypton.

**29.** A processing apparatus applying processing to a processing target in a process vessel by using highly reactive gas or chemical solution, the apparatus comprising

a member which is exposed to the gas or chemical solution and at least part of which is made of an aluminum alloy containing at least one of magnesium, strontium, and barium, and comprises an oxide coating film on a surface of said aluminum alloy,

wherein said oxide coating film includes an aluminum oxide and at least one of a magnesium oxide, a strontium oxide, and a barium oxide.

**30.** The processing apparatus according to claim 25,

wherein said aluminum alloy contains at least zirconium.

**31.** The processing apparatus according to claim 25,

wherein said aluminum alloy contains at least hafnium.

**32.** The processing apparatus according to claim 25,

wherein a content ratio of each of Fe, Mn, Cr, and Zn in said aluminum alloy is 0.01 weight % or less.

**33.** A method of plasma processing for applying plasma processing to a processing target in a process vessel, the method comprising the step of,

while keeping a temperature of the processing target made of aluminum or an aluminum alloy in the process vessel at 450°C or lower,

applying oxidation processing to a surface of the processing target in the process vessel by an oxygen radical generated by plasma.

**34.** A method of plasma processing for applying plasma processing to a processing target in a process vessel, the method comprising the steps of:

heating the processing target made of aluminum or an aluminum alloy in the process vessel to a temperature of 150°C to 250°C; and

applying oxidation processing to a surface of the processing target in the process vessel by an oxygen radical generated by plasma.

**35.** The method of plasma processing according to claim 33,

wherein the aluminum alloy contains at least magnesium.

**36.** The method of plasma processing according to claim 35,

wherein a content ratio of the magnesium is 0.5 weight % to solubility limit.

**37.** The method of plasma processing according to claim 33,

wherein the aluminum alloy contains at least strontium.

**38.** The method of plasma processing according to claim 33,

wherein the aluminum alloy contains at least barium.

**39.** The method of plasma processing according to claim 33,

wherein the aluminum alloy contains at least zirconium.

**40.** The method of plasma processing according to claim 33,

wherein the aluminum alloy contains at least hafnium.

**41.** The method of plasma processing according to claim 33,

wherein a content ratio of each of Fe, Mn, Cr, and Zn in the aluminum alloy is 0.01 weight % or less.

**42.** The method of plasma processing according to claim 33, further comprising the step of

performing pre-processing in which the processing target of the aluminum alloy is set at 450°C or lower in a hydrogen reducing atmosphere, before said step of applying the oxidation processing to the processing target.

**43.** The method of plasma processing according to claim 33,

wherein gas in which krypton gas is mixed in oxygen-containing gas is used in generating the oxygen radical.

**44.** The method of plasma processing according to claim 33,

wherein gas in which argon gas is mixed in oxygen-containing gas is used in generating the oxygen radical.

**45.** The method of plasma processing according to claim 33,

wherein the plasma is generated by a microwave.

FIG.1

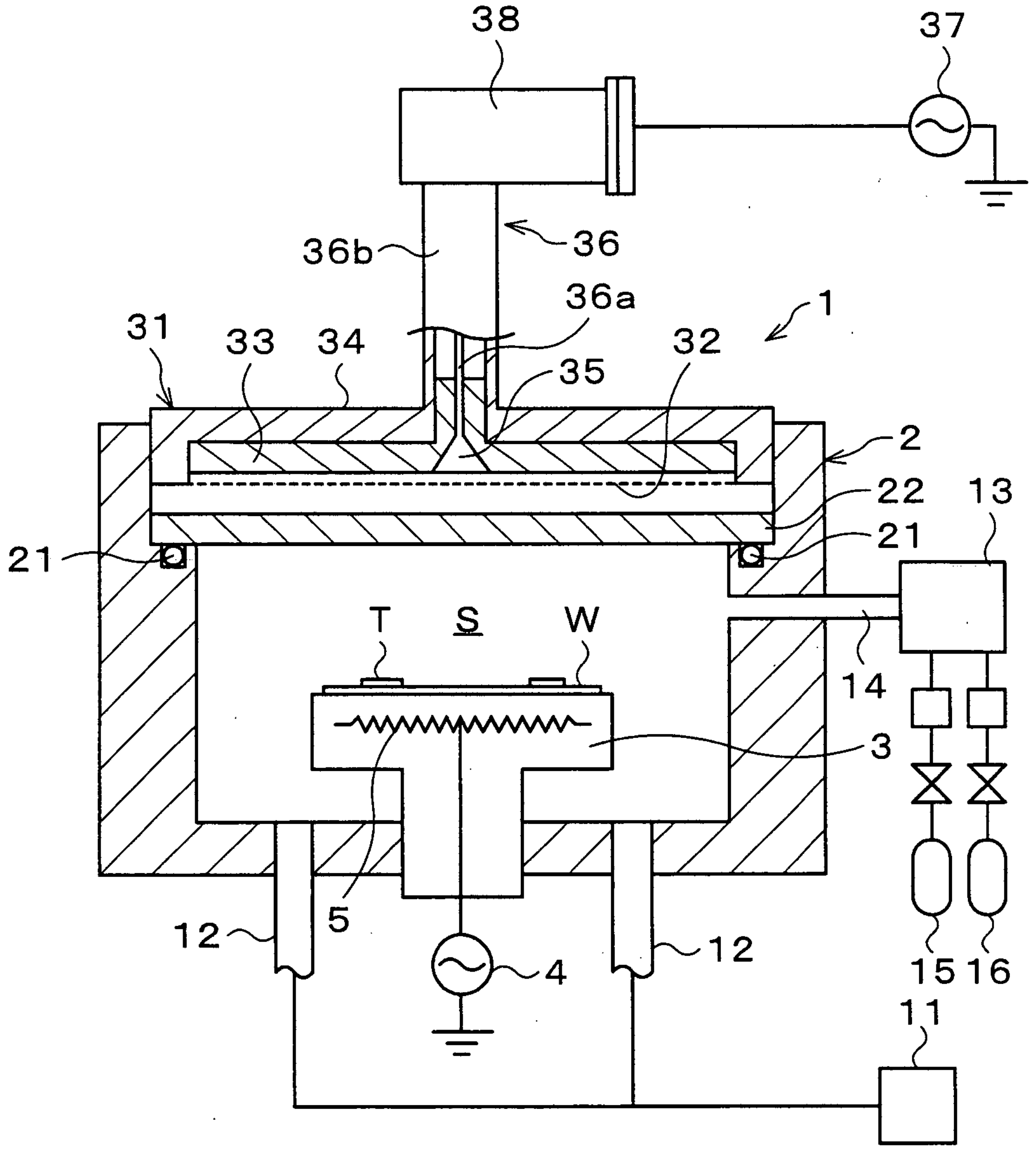
38
37
36b
36
36a
1
31
33
34
32
35
2
22
13
21
21
T
S
W
14
3
5
12
12
4
15
16
11

FIG.2

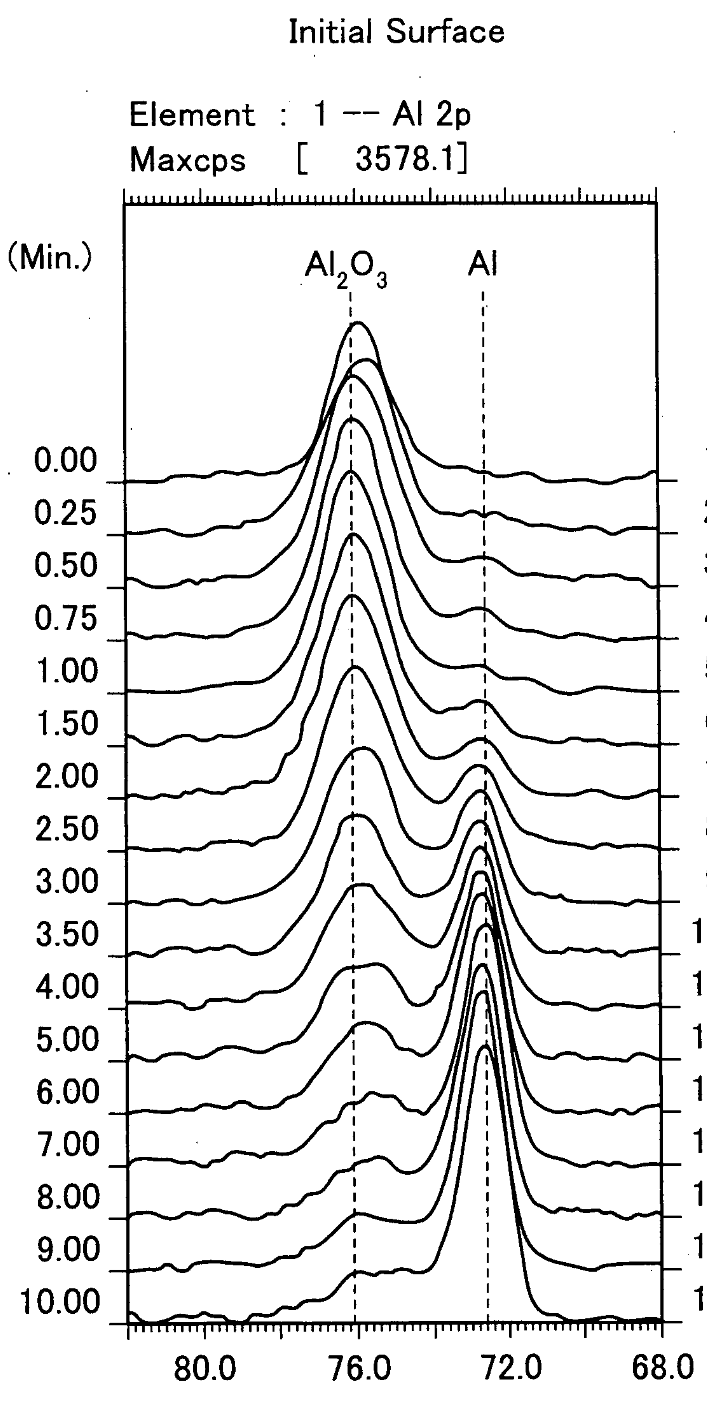
Initial Surface
Element : 1 -- Al 2p
Maxcps [ 3578.1]
(Min.)
$Al_2O_3$
Al
0.00
0.25
0.50
0.75
1.00
1.50
2.00
2.50
3.00
3.50
4.00
5.00
6.00
7.00
8.00
9.00
10.00
1
2
3
4
5
6
7
8
9
10
11
12
13
14
15
16
17
80.0
76.0
72.0
68.0

FIG.3

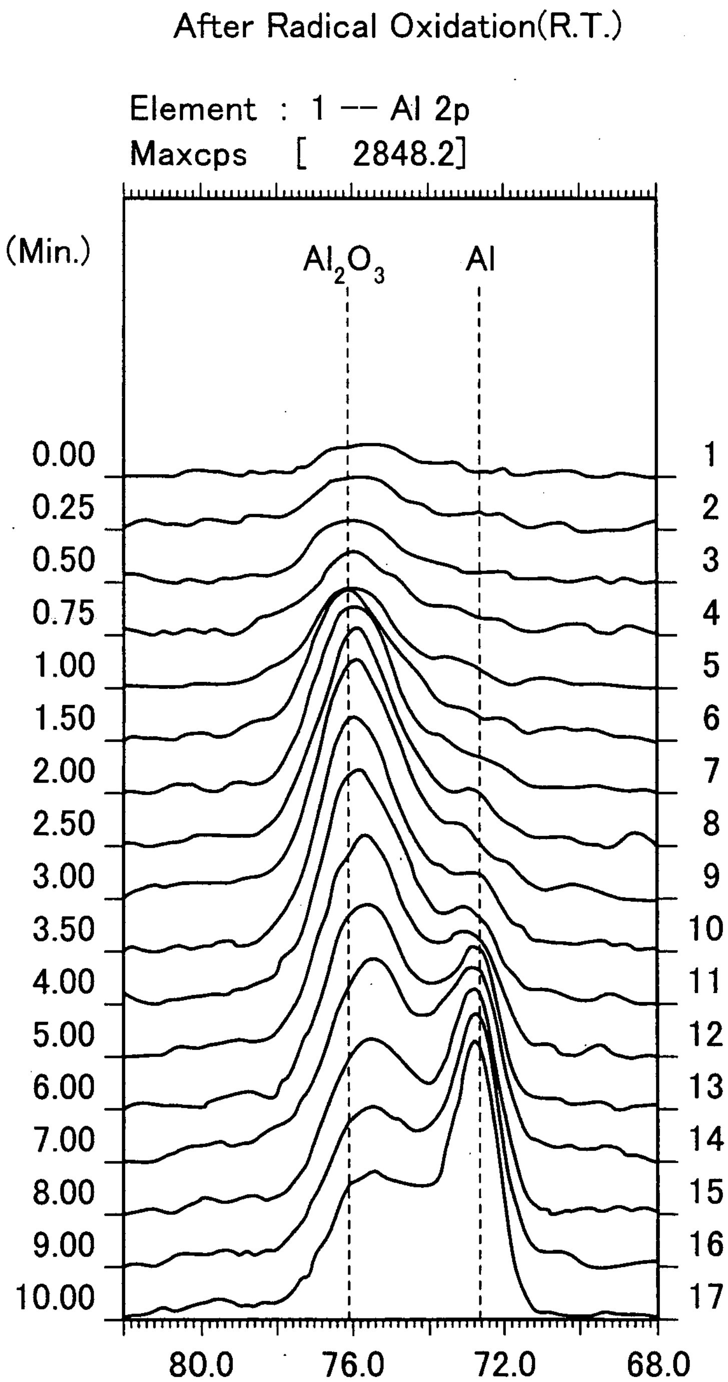
After Radical Oxidation(R.T.)
Element : 1 -- Al 2p
Maxcps [ 2848.2]
(Min.)
Al2O3
Al
0.00
0.25
0.50
0.75
1.00
1.50
2.00
2.50
3.00
3.50
4.00
5.00
6.00
7.00
8.00
9.00
10.00
1
2
3
4
5
6
7
8
9
10
11
12
13
14
15
16
17
80.0
76.0
72.0
68.0

FIG.4

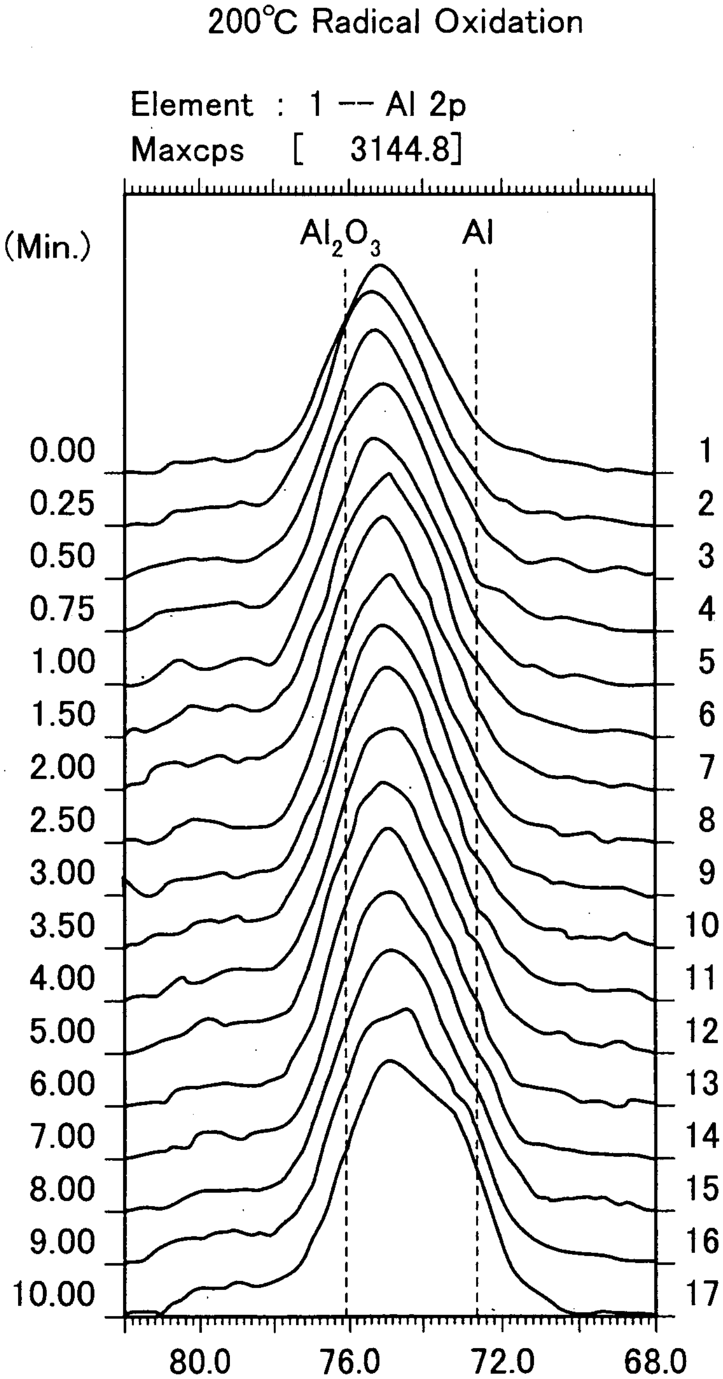
200°C Radical Oxidation
Element : 1 -- Al 2p
Maxcps [ 3144.8]
(Min.)
Al2O3
Al
0.00
0.25
0.50
0.75
1.00
1.50
2.00
2.50
3.00
3.50
4.00
5.00
6.00
7.00
8.00
9.00
10.00
1
2
3
4
5
6
7
8
9
10
11
12
13
14
15
16
17
80.0
76.0
72.0
68.0

FIG.5

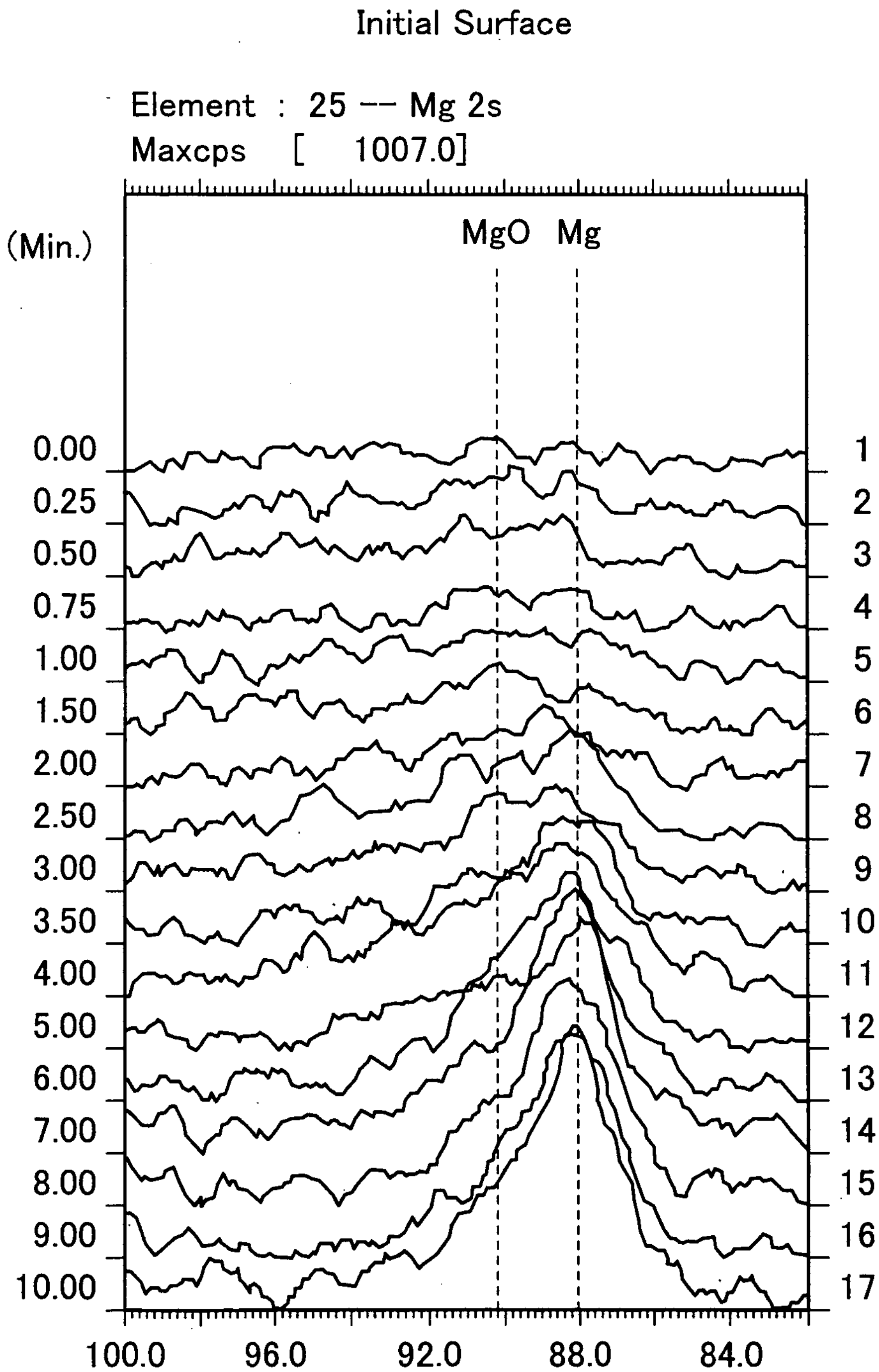
Initial Surface
Element : 25 -- Mg 2s
Maxcps [ 1007.0]
(Min.)
MgO
Mg
0.00
0.25
0.50
0.75
1.00
1.50
2.00
2.50
3.00
3.50
4.00
5.00
6.00
7.00
8.00
9.00
10.00
1
2
3
4
5
6
7
8
9
10
11
12
13
14
15
16
17
100.0
96.0
92.0
88.0
84.0

FIG.6

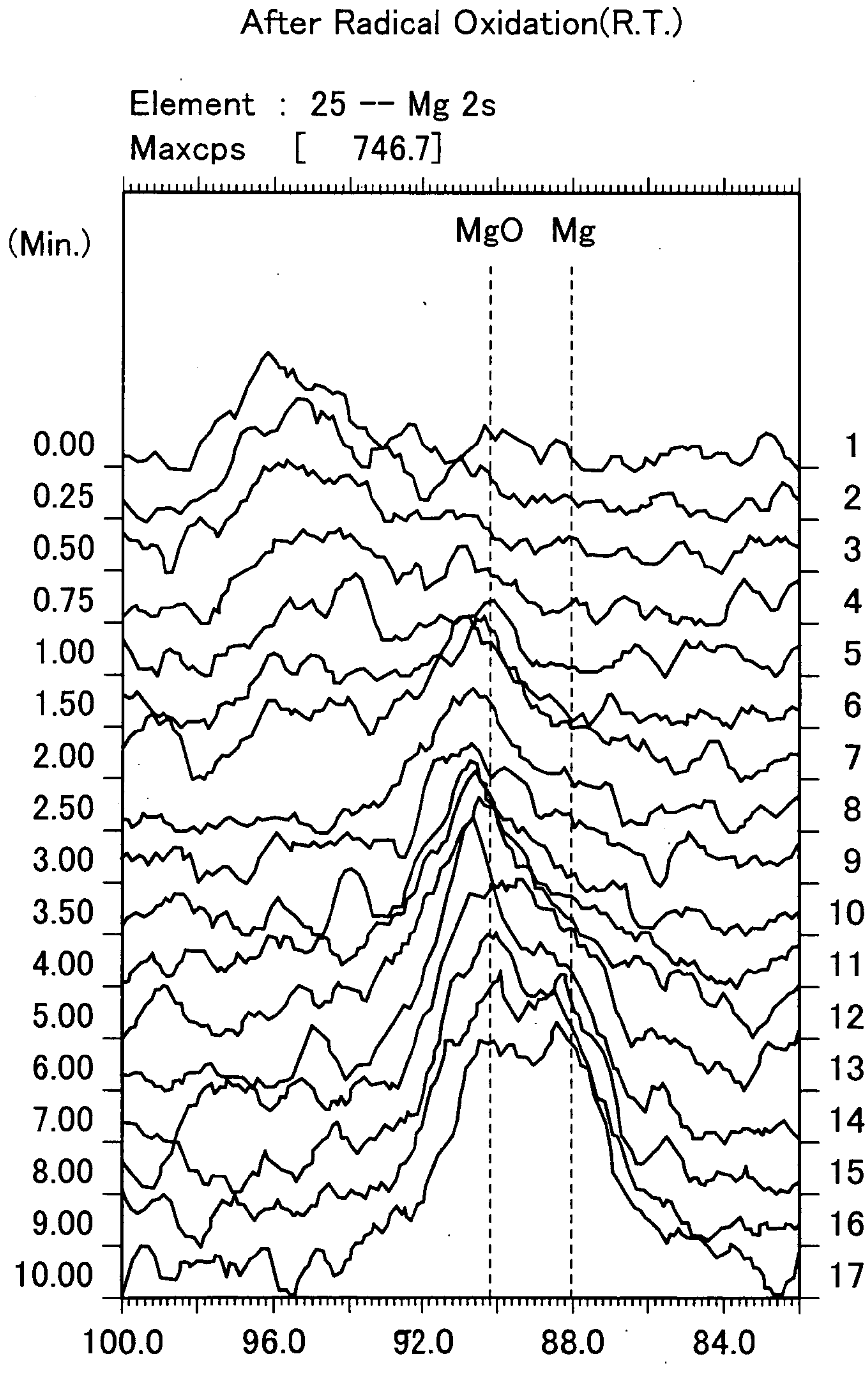
After Radical Oxidation(R.T.)
Element : 25 -- Mg 2s
Maxcps [ 746.7]
(Min.)
MgO Mg
0.00
0.25
0.50
0.75
1.00
1.50
2.00
2.50
3.00
3.50
4.00
5.00
6.00
7.00
8.00
9.00
10.00
1
2
3
4
5
6
7
8
9
10
11
12
13
14
15
16
17
100.0
96.0
92.0
88.0
84.0

FIG.7

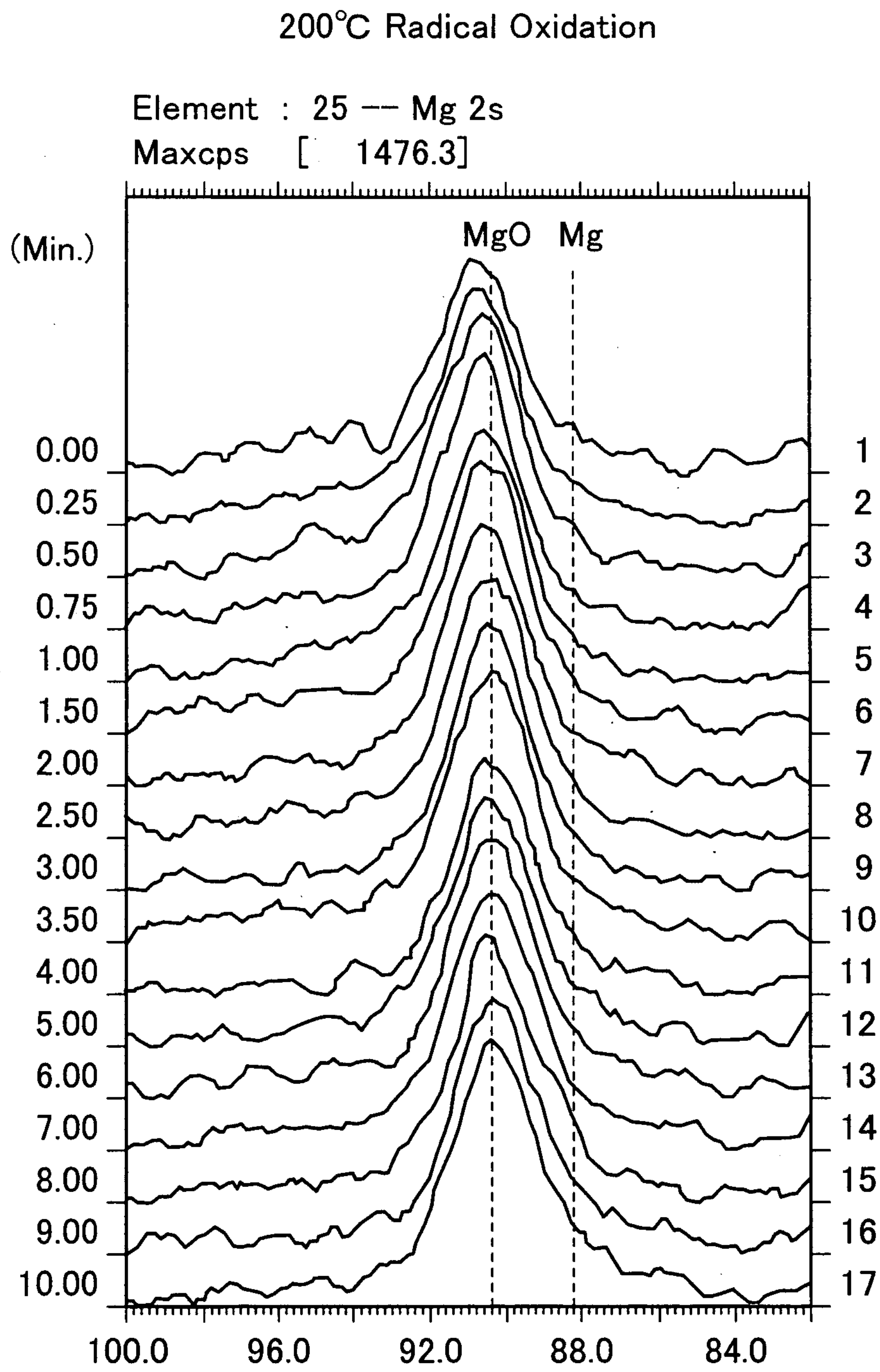
200°C Radical Oxidation
Element : 25 -- Mg 2s
Maxcps [ 1476.3]
(Min.)
MgO
Mg
0.00
0.25
0.50
0.75
1.00
1.50
2.00
2.50
3.00
3.50
4.00
5.00
6.00
7.00
8.00
9.00
10.00
1
2
3
4
5
6
7
8
9
10
11
12
13
14
15
16
17
100.0
96.0
92.0
88.0
84.0

FIG.8

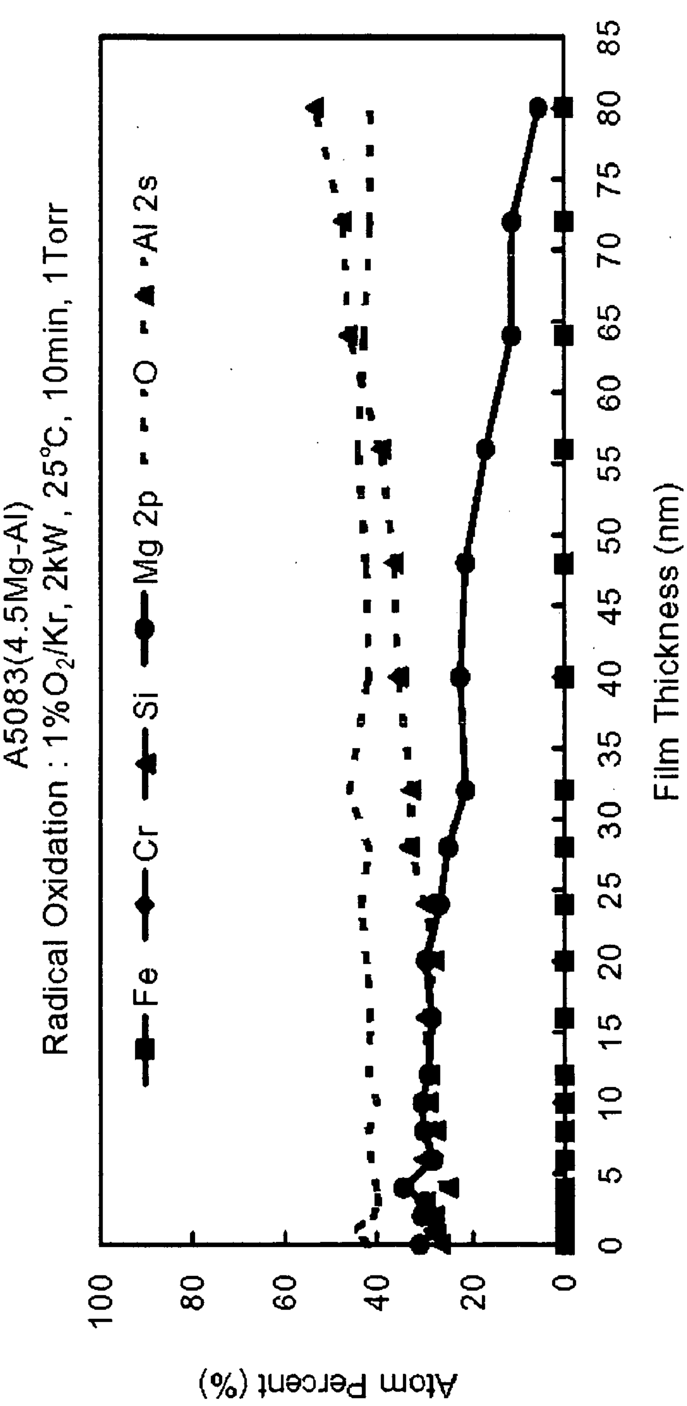
A5083(4.5Mg-Al)
Radical Oxidation : 1%$O_2$/Kr, 2kW, 25°C, 10min, 1Torr
Fe
Cr
Si
Mg 2p
O
Al 2s
Atom Percent (%)
100
80
60
40
20
0
0
5
10
15
20
25
30
35
40
45
50
55
60
65
70
75
80
85
Film Thickness (nm)

FIG.9

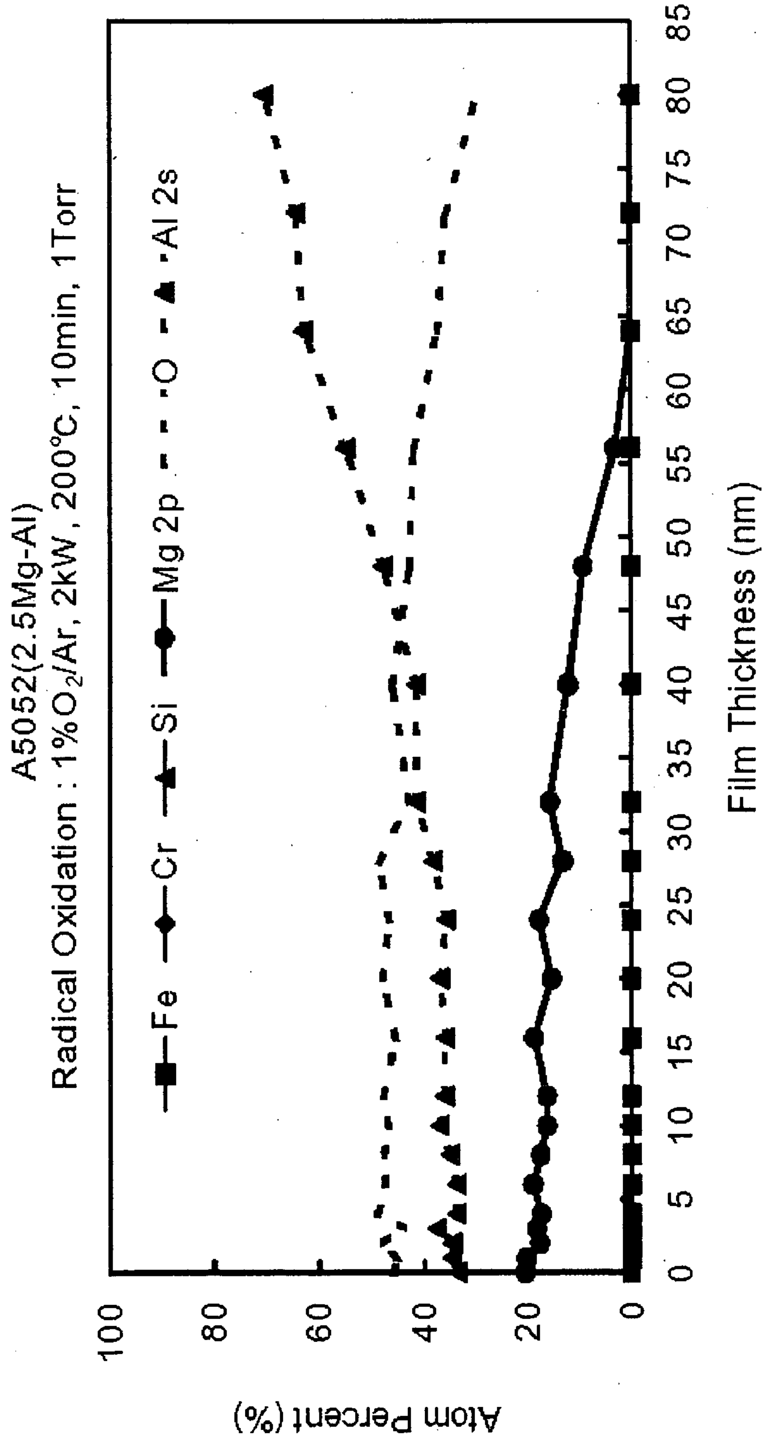
A5052(2.5Mg-Al)
Radical Oxidation : 1%O2/Ar, 2kW, 200°C, 10min, 1Torr
Fe
Cr
Si
Mg 2p
O
Al 2s
Atom Percent (%)
Film Thickness (nm)

FIG.10

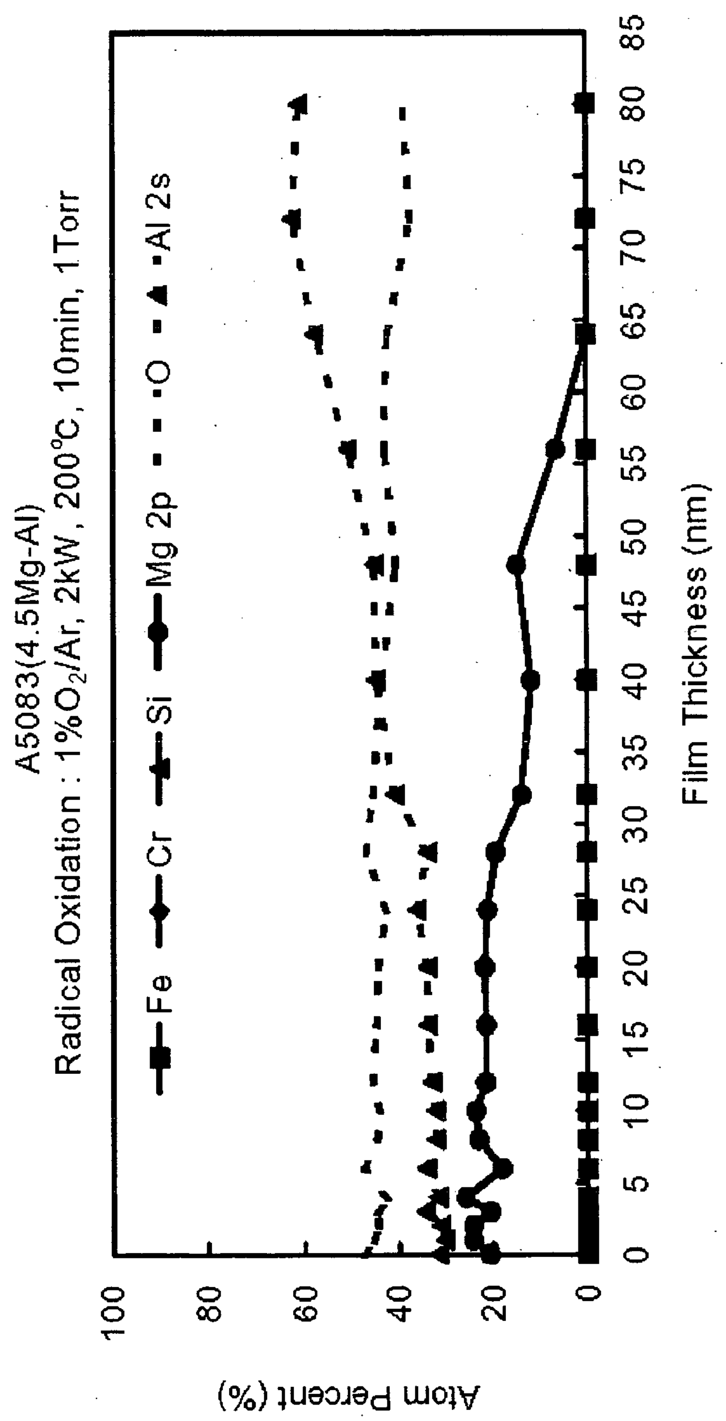
A5083(4.5Mg-Al)
Radical Oxidation : 1%O2/Ar, 2kW, 200°C, 10min, 1Torr
Fe
Cr
Si
Mg 2p
O
Al 2s
Atom Percent (%)
Film Thickness (nm)
100
80
60
40
20
0
0
5
10
15
20
25
30
35
40
45
50
55
60
65
70
75
80
85

FIG.11

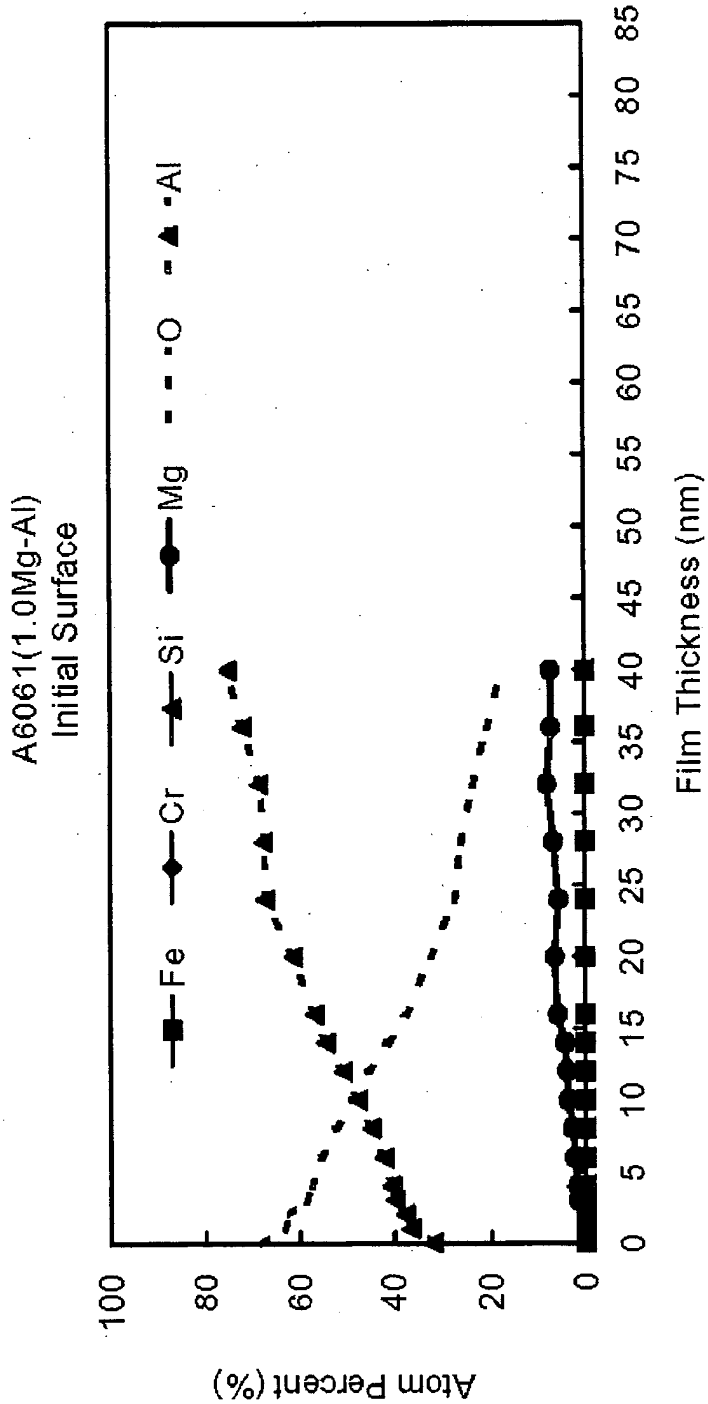
A6061(1.0Mg-Al)
Initial Surface
Fe
Cr
Si
Mg
O
Al
Atom Percent (%)
100
80
60
40
20
0
0
5
10
15
20
25
30
35
40
45
50
55
60
65
70
75
80
85
Film Thickness (nm)

FIG.12

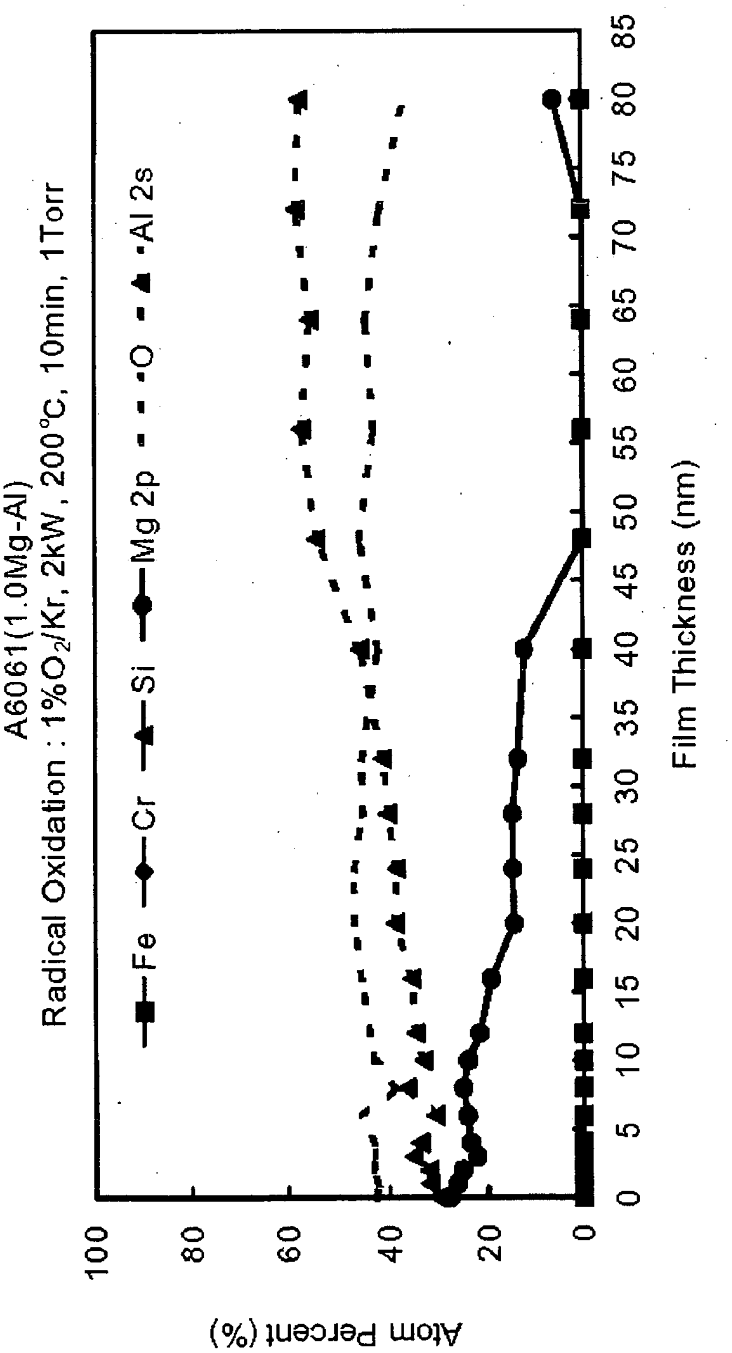
A6061(1.0Mg-Al)
Radical Oxidation : 1%$O_2$/Kr, 2kW, 200°C, 10min, 1Torr
Fe
Cr
Si
Mg 2p
O
Al 2s
Atom Percent (%)
100
80
60
40
20
0
0
5
10
15
20
25
30
35
40
45
50
55
60
65
70
75
80
85
Film Thickness (nm)

FIG.13

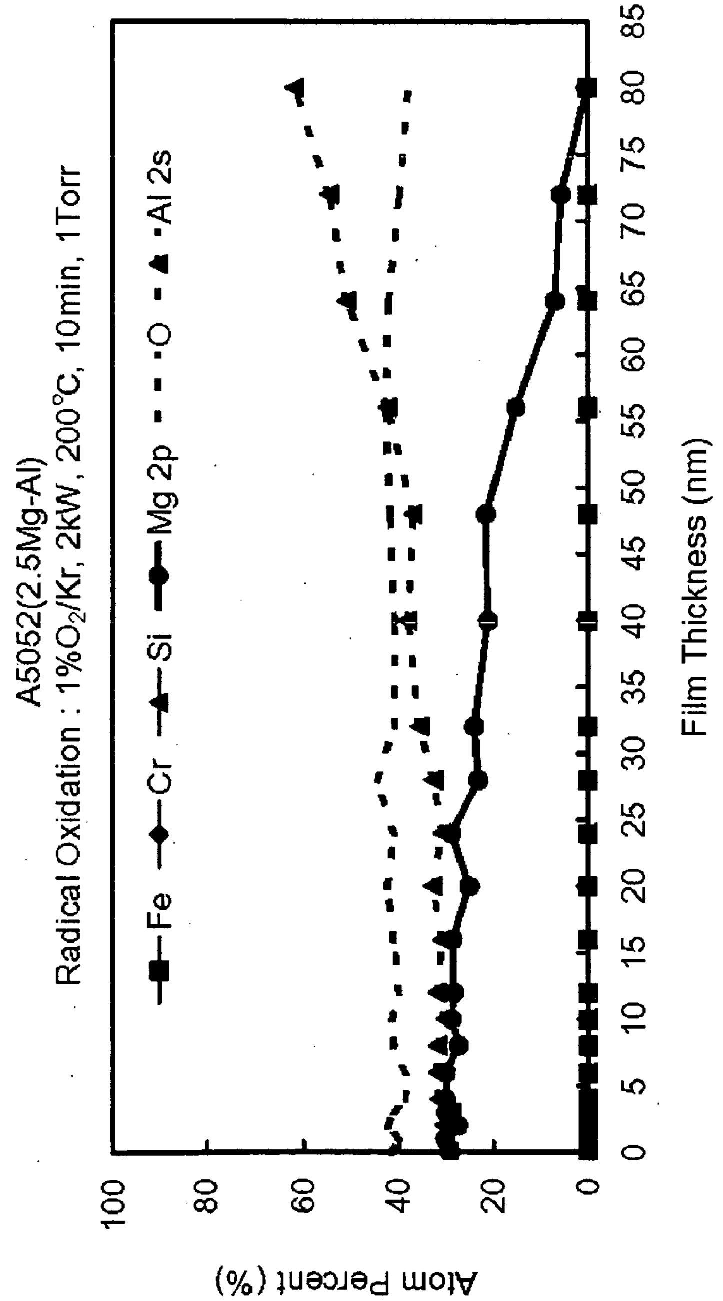
A5052(2.5Mg-Al)
Radical Oxidation : 1%$O_2$/Kr, 2kW, 200℃, 10min, 1Torr
Fe
Cr
Si
Mg 2p
O
Al 2s
Atom Percent (%)
0
20
40
60
80
100
Film Thickness (nm)
0
5
10
15
20
25
30
35
40
45
50
55
60
65
70
75
80
85

FIG.14

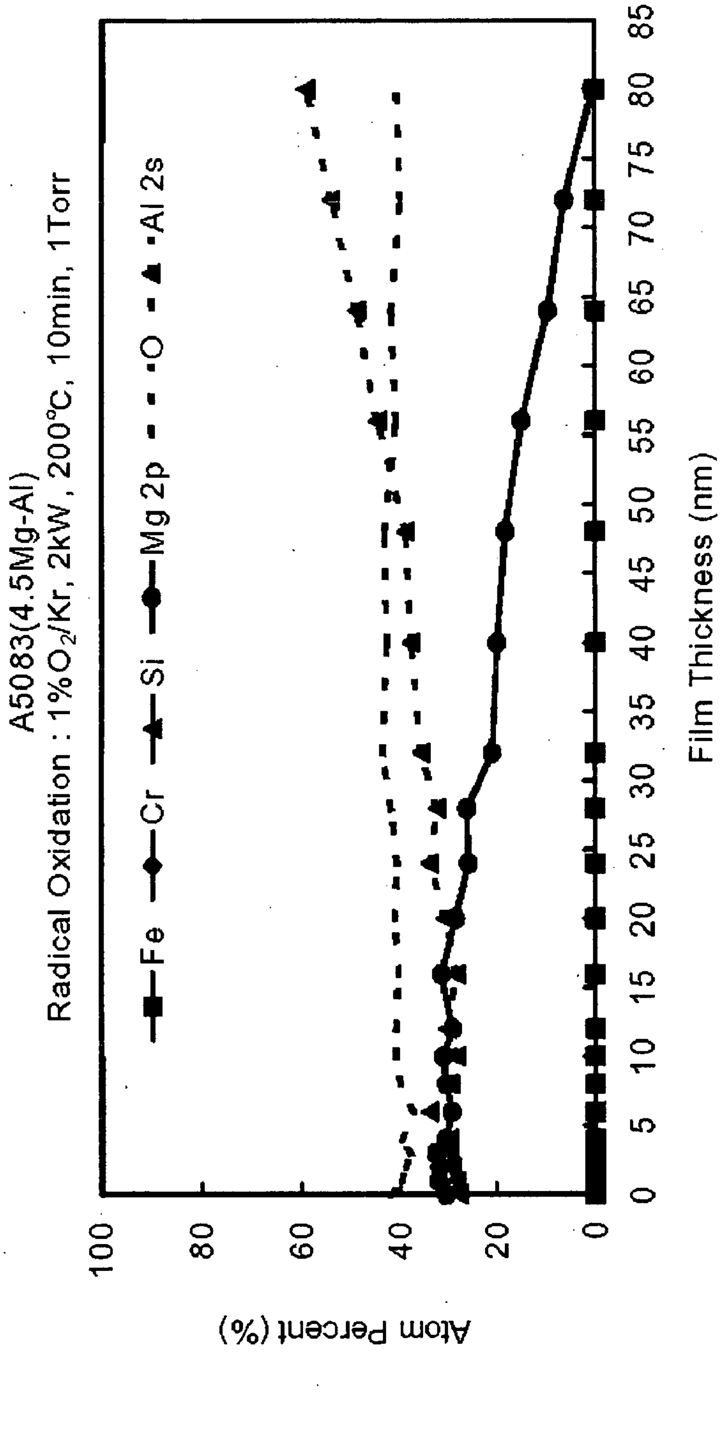
A5083(4.5Mg-Al)
Radical Oxidation : 1%O2/Kr, 2kW, 200°C, 10min, 1Torr
Fe
Cr
Si
Mg 2p
O
Al 2s
Atom Percent (%)
Film Thickness (nm)
0
20
40
60
80
100
0 5 10 15 20 25 30 35 40 45 50 55 60 65 70 75 80 85

## EXPLANATION OF CODES

| | |
|---|---|
| 1 | PLASMA PROCESSING APPARATUS |
| 2 | PROCESS VESSEL |
| 3 | SUSCEPTOR |
| 5 | HEATER |
| 22 | DIELECTRIC WINDOW |
| 31 | ANTENNA MEMBER |
| 32 | RADIAL SLOT ANTENNA |
| 37 | MICROWAVE SUPPLY DEVICE |
| W | WAFER |
| T | PROCESSING TARGET |

## INTERNATIONAL SEARCH REPORT

International application No.
PCT/JP2004/000179

**A. CLASSIFICATION OF SUBJECT MATTER**
Int.Cl[7] C23C8/36, H05H1/46, H01J37/32, C22C21/06

According to International Patent Classification (IPC) or to both national classification and IPC

**B. FIELDS SEARCHED**

Minimum documentation searched (classification system followed by classification symbols)
Int.Cl[7] C23C8/36, H05H1/46, H01J37/32, C22C21/06

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br><br><br><br>A | JP 59-209727 A (Hajime ISHIMARU), 28 November, 1984 (28.11.84), Full text (Family: none) | 1-5,9-13, 17-21,25-29, 33,35,36, 43-45<br>6-8,14-16, 22-24,30-32, 34,37-42 |
| Y | JP 63-270536 A (Showa Aluminum Corp.), 08 November, 1988 (08.11.88), Full text (Family: none) | 1-5,9-13, 17-21,25-29, 33,35,36, 43-45 |

☒ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 06 April, 2004 (06.04.04) | 20 April, 2004 (20.04.04) |
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP2004/000179

C (Continuation). DOCUMENTS CONSIDERED TO BE RELEVANT

| Category* | Citation of document, with indication, where appropriate, of the relevant passages | Relevant to claim No. |
|---|---|---|
| Y | US 5062900 A1 (INSTITUT DE RECHERCHES DE LA SIDERURGIE FRANCAISE), 05 November, 1991 (05.11.91), Claims 1, 8; column 1, line 1 to column 2, line 26 & JP 3-500550 A & EP 340077 A1 | 1-5,9-13, 17-21,25-29, 33,35,36, 43-45 |
| A | EP 1170394 A2 (ALCOA INC.), 09 January, 2002 (09.01.02), Par. No. [0007] & JP 2002-53925 A & US 6562154 B | 6,7,14,15, 22,23,30,31, 39,40 |

Form PCT/ISA/210 (continuation of second sheet) (July 1998)